# EUROPEAN PATENT APPLICATION

(11) **EP 4 851 644 A1**
(43) Date of publication of application: **09.12.2026**
(21) Application number: 25747371.0
(22) Date of filing: 01.02.2025
(51) Int. Cl.: G01R 31/34, G01R 31/12, G01R 31/72

(54) **PARTIAL DISCHARGE DETECTION DEVICE FOR AN ELECTRIC MACHINE**

(30) Priority: 01.02.2024 US 202463548575 P
(71) Applicant: Weg Equipamentos Elétricos S.A., 89256900 Jaraguá do Sul (BR)
(72) Inventor: TEDESCO, Duani, 89252-400 Jaraguá do Sul (BR); SCIEPIET, Marco Aurélio, 89255-677 Jaraguá do Sul (BR); MACIEL, Marcus Vinicius Pinter, 89251-500 Jaraguá do Sul (BR); SEIDEL, Fabiana, Jaraguá do Sul, SC 89266-700 (BR); PEREIRA, Jonas Formanski, Jaraguá do Sul, SC 89258-670 (BR); SILVA, Thiago da, Jaraguá do Sul, SC 83254-188 (BR)
(74) Representative: Plasseraud IP
(86) International application number: PCT/BR2025/050037
(87) International publication number: WO 2025/160649

(57) **Abstract**

The present invention relates to a device for detecting partial discharges in an electric machine, comprising an antenna component (3) for capturing and transmitting signals in the form of electromagnetic waves; and an acquisition component (2) connected to the antenna component (3) to receive the transmitted signals, the acquisition component (2) comprising a filter capable of filtering the received signals, allowing only partial discharge pulse frequency signals to pass, a module capable of counting a number of partial discharges within a defined time interval, and a wireless device module; wherein the antenna component (3) is fixed internally to a connection box (4) of the machine.

## Description

### FIELD OF INVENTION

The present invention relates to the monitoring of partial discharges in electrical machine.

### BACKGROUND OF THE INVENTION

The phenomenon of partial discharges-which comprise small electrical discharges that can occur within an insulation system-is known in the state of the art.

Partial discharges are low-energy discharges that, if they act continuously, prematurely degrade the insulation of the electrical machine. Erosion results in a decrease in the thickness of the insulating material, leading to progressive loss of dielectric properties, until the breakdown voltage reaches a level below the peak level of the applied voltage, then causing insulation failure.

In the case of medium-voltage electrical machines, the insulation system is designed to withstand partial discharges for long periods of time. In the case of low-voltage electrical machines with primarily organic insulation components, the insulation system tends to fail rapidly in the presence of partial discharge.

Low-voltage motors driven by variable frequency drives are particularly vulnerable to partial discharges. This susceptibility arises due to the nature of the voltage pulses generated by inverters, which often have high amplitude and steep rise times (high dV/dt). These rapid voltage changes can induce stress on the motor insulation system, leading to the formation of partial discharges. Over time, these discharges can degrade the insulation, potentially resulting in reduced motor life, performance problems, or even complete failure.

Since partial discharges occur prior to failure, proper monitoring and detection of these discharges can provide sufficient time to implement maintenance and preventive measures, thereby extending the service life of the insulation and, consequently, the electrical machine.

### OBJECTIVES OF THE INVENTION

It is an object of the present invention to provide a partial discharge detection device for an electric machine and to enable the implementation of maintenance and preventive measures.

It is another objective of the present invention to provide a partial discharge detection device for an electrical machine and prevent the occurrence of failures in the insulation of the electrical machine.

It is yet another object of the present invention to provide a low-cost partial discharge detection device for an electric machine.

It is a further object of the present invention to provide a partial discharge detection device for an electric machine in operation (online), without the need for invasive interventions.

It is another object of the present invention to provide a partial discharge detection device for an electric machine capable of counting the number of partial discharges within a defined time interval.

It is another object of the present invention to provide a partial discharge detection device for an electric machine capable of wirelessly transmitting the occurrence of partial discharges.

### SUMMARY OF THE INVENTION

The present invention relates to a device for detecting partial discharges in an electrical machine. The device comprises an antenna component for capturing signals in the form of electromagnetic waves; and an acquisition component connected to the antenna component to receive the signals, the acquisition component comprising a filter capable of filtering the received signals by selecting partial discharge pulse frequency signals, a module capable of counting a number of partial discharges within a defined time interval; and a wireless device module; wherein the antenna component is fixed internally to a connection box of the machine.

In embodiments of the invention, the module capable of counting the number of partial discharges has configurable time intervals.

In one embodiment of the present invention, the antenna component comprises a coaxial cable, wherein a first end of the coaxial cable is configured to connect to the acquisition component and a second end of the coaxial cable is configured to connect to a connection box of the electric machine.

**I**n this embodiment, the second end of the coaxial cable may, but is not restricted to, being positioned near a terminal board of the connection box.

In one embodiment of the invention, the filter of the acquisition component is a high-pass filter.

The acquisition component may be housed in an enclosure and may, but is not restricted to, be battery powered, being a stand-alone component that may be attached to the electrical machine or other support or device.

### BRIEF DESCRIPTION OF THE DRAWINGS

The present invention will be described below in more detail, with reference to the attached drawings, in which:
Figure 1 - is a schematic illustration of the phenomenon of partial discharges;
Figure 2 is an illustration of a partial discharge detection device for an electrical machine according to an embodiment of the present invention;
Figure 3 is an illustration of the end of an antenna component of the partial discharge detection device according to an embodiment of the present invention;
Figure 4 is a schematic illustration of the connection between the antenna component of the partial discharge detection device according to an embodiment of the present invention and a connection box of an electrical machine;
Figure 5 is a schematic illustration of testing of the partial discharge detection device according to an embodiment of the present invention.

### DETAILED DESCRIPTION OF THE INVENTION

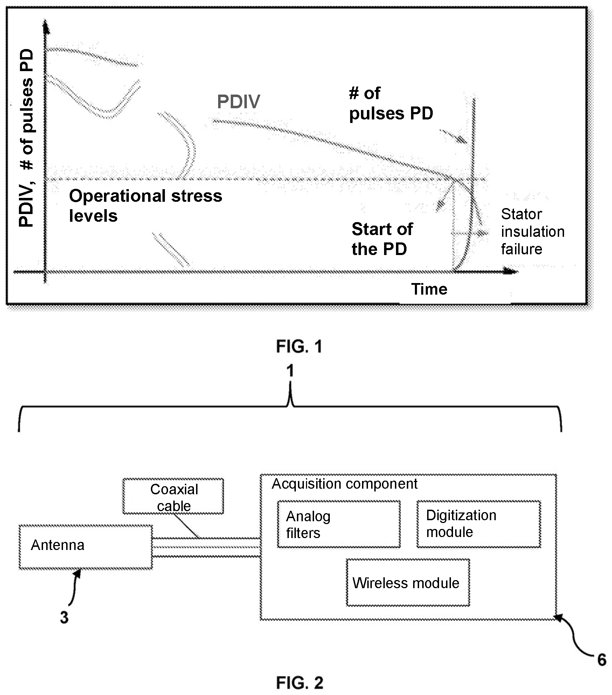

Figure 1 shows a schematic illustration of the partial discharge phenomenon and its impact on the service life of the electrical machine.

Thus, the figure shows the occurrence of partial discharges (number of pulses) over time and the moment of stator insulation failure, when the voltage rises to a level exceeding the breakdown voltage.

The present invention relates to a device for detecting partial discharges in electrical machines, preferably low-voltage electrical machines 1, which, in the illustrated embodiment, comprises an acquisition component 2 and an antenna component 3 for capturing electromagnetic waves.

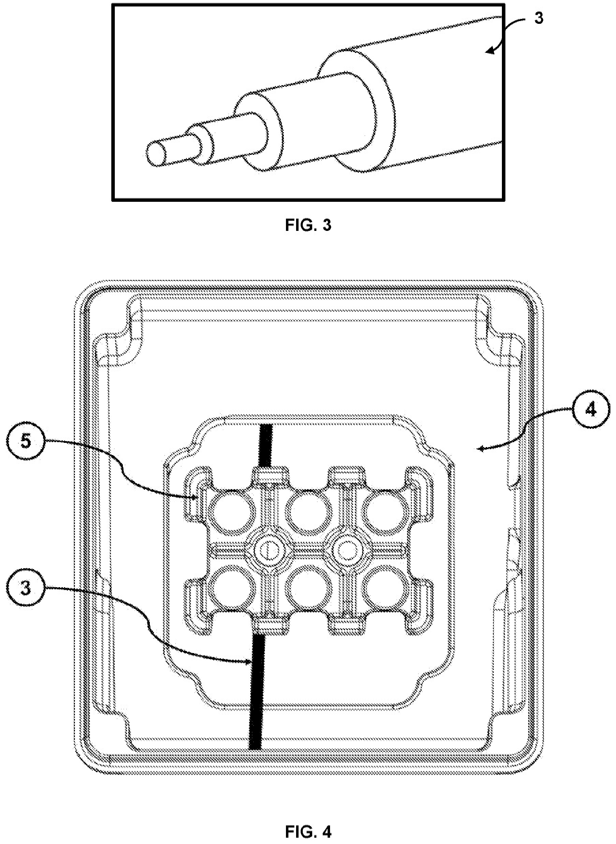

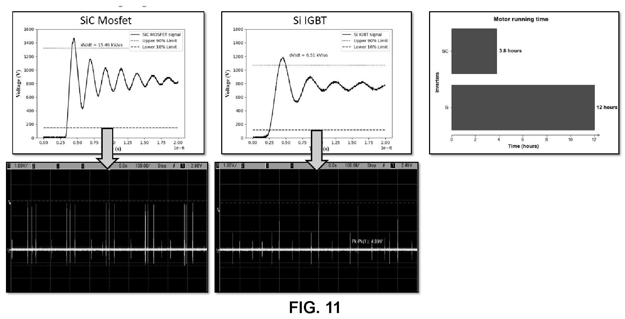

As best illustrated in Figure 3, in the illustrated embodiment, the antenna component 3 comprises a coaxial cable comprising a central conductor coated with an insulator, an outer conductor with openings, and a jacket.

In one embodiment of the invention, the antenna component 3 of the device according to the present invention can advantageously be placed in the connection box 4 of an electric motor (see the exemplary illustration in Figure 4), eliminating the need to open the machine to make the connection, the need for any modification to the machine housing, or the need to decouple the load. Thus, the machine can remain fully operational while the antenna component 3 is mounted on or removed from the machine.

Thus, a first end of the coaxial cable may be configured to connect to the acquisition component 2 and a second end of the coaxial cable may be stripped to form the antenna.

In one embodiment of the invention, the second end of the coaxial cable is configured to be positioned within the connection box 4 of the electrical machine, as close as possible to the opening of the stator housing of the machine.

As illustrated in figure 4, in the illustrated embodiment, the connection to the connection box 4 can be made by positioning the conductor of the antenna component 3 inside the connection box 4, close to the terminal board 5 of the connection box 4, and, more specifically, in a region closer to the opening that gives access to the internal volume of the machine.

In the embodiment illustrated in the figures, the acquisition component 2 comprises a filter, such as a high-pass filter, capable of passing the frequency signals of the partial discharge pulses, a module capable of counting the number of partial discharges within a time interval, and a wireless communication module.

In one embodiment of the invention, the module capable of counting the number of partial discharges within a defined time interval comprises a series of latch comparators to route the signal to a microcontroller.

In this regard, it should be noted that partial discharge pulses exhibit specific characteristics that can distinguish them from other signals; the characteristic frequency spectrum of partial discharges for the equipment under analysis is generally known to the person skilled in the art.

It should also be noted that the module capable of counting the number of partial discharges within a time interval can reduce the amount of data to be transmitted wirelessly.

The module capable of counting the number of partial discharges can also be configured to count the number of discharges over different time intervals.

In the illustrated embodiment of the present invention, the acquisition component 2 may be housed in an enclosure configured to be attached to the electric machine, preferably external to the connection box 4, or to another base or support. The acquisition component 2 may be powered by batteries, making it portable and independent, although it is not limited to this power source. Partial discharges can be detected while the machine is in operation.

Figure 5 illustrates partial discharge detection in inverter-fed motors with different voltage variation characteristics at the moment of switching, showing the detected partial discharges in the bottom graphs and the operating time until failure in the comparative graph on the side.

Having described examples of embodiments of the present invention, it must be understood that the scope of the present invention covers other possible variations of the described inventive concept, being limited only by the content of the claims alone, including possible equivalents.

## Claims

1. A device for detecting partial discharges in an electrical machine, **characterized by the fact that** it comprises:
an antenna component (3) for capturing and transmitting signals in the form of electromagnetic waves; and
an acquisition component (2) connected to the antenna component (3) to receive the transmitted signals, the acquisition component (2) comprising a filter capable of filtering the received signals, allowing only partial discharge pulse frequency signals to pass,
a module capable of counting a number of partial discharges within a defined time interval; and
a wireless communication module;
wherein the antenna component (3) is fixed internally to a connection box (4) of the machine.

2. The device according to claim 1, **characterized by the fact that** the antenna component (3) comprises a coaxial cable, wherein a first end of the coaxial cable is configured to connect to the acquisition component (2) and a second end of the coaxial cable is configured to connect to the connection box (4) of the electric machine.

3. The device according to claim 2, **characterized by the fact that** the second end of the coaxial cable is positioned near a terminal board (5) of the connection box.

4. The device according to claim 1, **characterized by the fact that** the module capable of counting the number of partial discharges has configurable time intervals.

5. The device according to any one of claims 1 to 4, **characterized by the fact that** the filter of the acquisition component (2) is a high-pass filter.

6. The device according to any one of claims 1 to 5, **characterized by the fact that** the acquisition component (2) is housed in an enclosure.
